(19) Europäisches Patentamt
European Patent Office
Office européen des brevets

(11) Publication number: 0 118 748 A1

# (12) EUROPEAN PATENT APPLICATION

(21) Application number: 84101195.0

(22) Date of filing: 06.02.84

(51) Int. Cl.³: C 08 G 59/20
C 08 L 63/00, C 08 G 59/68
C 08 K 5/15

(30) Priority: 07.02.83 US 464564

(43) Date of publication of application:
19.09.84 Bulletin 84/38

(84) Designated Contracting States:
BE DE FR GB IT NL

(71) Applicant: UNION CARBIDE CORPORATION
Old Ridgebury Road
Danbury Connecticut 06817(US)

(72) Inventor: Koleske, Joseph Victor
1513 Brentwood Road
Charleston West Virginia 25314(US)

(72) Inventor: Kwiatkowski, George Thomas
5 Forest Lane
Green Brook New Jersey 08812(US)

(74) Representative: Schmied-Kowarzik, Volker, Dr. et al,
Patentanwälte Dr. V. Schmied-Kowarzik Dipl.-Ing. G. Dannenberg Dr. P. Weinhold Dr. D. Gudel Dipl.-Ing. S. Schubert Dr. P. Barz Siegfriedstrasse 8
D-8000 München 40(DE)

## (54) Blends of epoxy containing organic materials.

(57) Described herein are photocopolymerizable compositions suitable for photopolymerization comprising an epoxide containing two or more epoxy groups, and a substituted cycloaliphatic monoepoxide. These compositions are suitable for use in a variety of applications in the field of protective coatings.

EP 0 118 748 A1

BACKGROUND OF THE INVENTION

Epoxides have gained wide acceptance in protective coatings in electrical and structural applications due to their exceptional combination of properties such as toughness, adhesion, chemical resistance, and superior electrical properties.

Epoxides may be cured by ultraviolet light (UV) or thermally. UV cure involves the use of a photoinitiator with the epoxide. When this system is radiated with ultraviolet light, the formulation is cured into a coating. However, many of the epoxides used in these systems have a relatively high viscosity. To reduce this viscosity, the systems may be warmed which results in a decrease in viscosity.

Polyols are often combined with epoxides to improve their properties. When the polyols are of sufficient molecular weight, for example, to improve flexibility of the epoxide coatings, they further increase the viscosity of the formulation. If they are of low molecular weight (such as diethylene glycol, tripropylene glycol, etc.), they may decrease the viscosity of the formulation, but they do not enhance the flexibility and/or toughness of the system and may make it more brittle. In addition, usually only small amounts of such low molecular weight compounds--including alcohols--can be employed or properties of the resultant coating will be deleteriously affected. The low molecular weight alcohols exhibit the most detrimental effect on crosslink density and the coating solvent

resistance and hardness. The affinity of any given compound for the other components will also have an effect on the viscosity reducing power of any given diluent. As the molecular weight is decreased, there often is a concommitant increase in volatility which can result in loss of a given compound during the radiation-cure step or in a subsequent thermal curing operation. Moderate levels of mono-glycidyl compounds such as butyl glycidyl ether, etc., are often used as epoxy diluents but in UV curing systems they retard the curing process. Solvents, in general, could be used to reduce viscosity; but they would need to be volatilized at some point in the coating process. However, such volatilization would negate the benefits of radiation curable systems which are considered to be essentially 100 percent solids coating systems.

What is needed for radiation cure systems is a rapidly curable reactive diluent that will cure into the final product, have a marked effect in lowering viscosity, be of low volatility during the radiation cure operation, and not retard the curing rate.

## THE INVENTION

It has now been found that when a substituted cycloaliphatic monoepoxide is added to a composition containing an epoxide which has two or more epoxy groups, the substituted cycloaliphatic monoepoxide has a marked effect in lowering the viscosity of the composition. Also, the substituted cycloaliphatic monoepoxide is not volatilized during the radiation cure operation. Further, the use of the substituted cycloaliphatic monoepoxide in the

composition containing the epoxide allows a formulator a great deal of latitude in devising systems that can be applied by roll coating, spray, and other methods of application. Its use also allows an end user to apply such films in a very thin form which can result in significant cost savings. Moreover, the substituted cycloaliphatic monoepoxide is capable of coreacting with the epoxide in the composition to provide coatings having an excellent combination of properties.

The composition of this invention suitable for photocopolymerizable comprises:

(a) an epoxide containing two or more epoxy groups, and

(b) a substituted cycloaliphatic monoepoxide.

The composition may optionally contain a photoinitiator that generates a species capable of polymerizing epoxides when subjected to a radiation source.

The substituted cycloaliphatic monoepoxide of this invention is substituted with alkyl of 1 to 9 carbon atoms, halogen, oxygen, ether, ester or vinyl radicals. Preferably, the substituted cycloaliphatic monoepoxide is vinyl substituted cycloaliphatic monoepoxide and is preferably selected from one or more of the following:

(1) 4-vinyl cyclohexane monoepoxide having the formula:

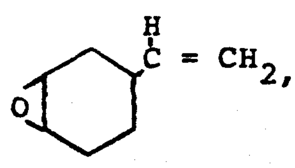

(2) norbornene monoepoxide having the formula:

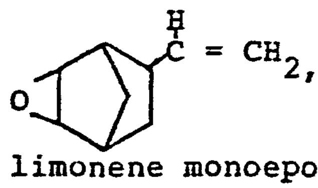

or

(3) limonene monoepoxide having the formula:

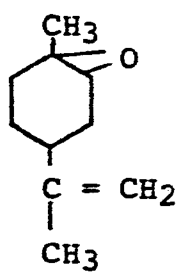

The substituted cycloaliphatic monoepoxide is used in the composition in amounts of from about 0.1 to about 95, preferably from about 1 to about 60, and most preferably, from about 3 to about 30 weight percent.

The epoxides which may be used herein contain two or more epoxy groups having the formula:

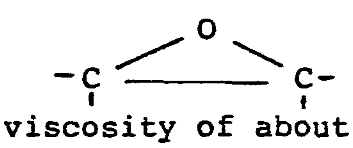

and having a viscosity of about 200, or higher, centipoise at 25°C. The.epoxy groups can be terminal epoxy groups or internal epoxy groups. The epoxides are primarily cycloaliphatic epoxides. These cycloaliphatic epoxide resins may be blended with minor amounts of glycidyl type epoxides, aliphatic epoxides, epoxy cresol novolac resins, epoxy phenol novolac resins, polynuclear phenol-glycidyl ether-derived resins, aromatic and

heterocyclic glycidyl amine resins, hydantoin epoxy resins, and the like, and mixtures thereof. The cycloaliphatic epoxide resins may also be blended with minor amounts of cycloaliphatic epoxides having a viscosity of less than 200 centipoise such as:

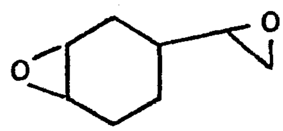

or

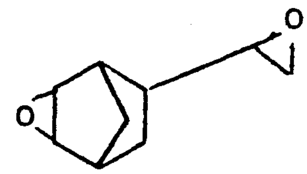

Further, such cycloaliphatic epoxides may be blended with the blends of cycloaliphatic epoxides and other epoxides described above. These epoxides are well known in the art and many are commercially available.

Suitable cycloaliphatic epoxide resins for purposes of this invention are those having an average of two or more epoxy groups per molecule. Illustrative of suitable cycloaliphatic epoxides are the following:

<u>FORMULA 1</u>

Diepoxides of cycloaliphatic esters of dicarboxylic acids having the formula:

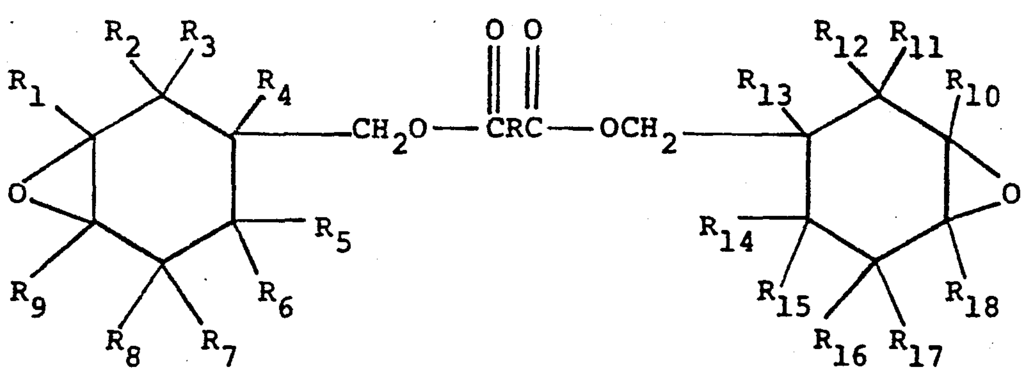

wherein $R_1$ through $R_{18}$ can be the same or different, are hydrogen or alkyl radicals generally

containing one to nine carbon atoms inclusive, and preferably containing one to three carbon atoms, inclusive, as for example methyl, ethyl, n-propyl, n-butyl, n-hexyl, 2-ethylhexyl, n-octyl, n-nonyl and the like; R is a valence bond or a divalent hydro carbon radical generally containing one to twenty carbon atoms, inclusive, and preferably, containing four to six carbon atoms, inclusive, as for example, alkylene radicals, such as trimethylene, tetramethylene, pentamethylene, hexamethylene, 2-ethylhexamethylene, octamethylene, nonamethylene, hexadecamethylene and the like; cycloaliphatic radicals, such as 1,4-cyclohexane, 1,3-cyclohexane, 1,2-cyclohexane, and the like.

Particularly desirable epoxides, falling within the scope of Formula I, are those wherein $R_1$ through $R_{18}$ are hydrogen and R is alkylene containing four to six carbon atoms.

Among specific diepoxides of cycloaliphatic esters of dicarboxylic acids are the following:

bis(3,4-epoxycyclohexylmethyl)oxalate,
bis(3,4-epoxycyclohexylmethyl)adipate,
bis(3,4-epoxy-6-methylcyclohexylmethyl) adipate,
bis(3,4-epoxycyclohexylmethyl)pimelate, and the like.

Other suitable compounds are described in, for example, U.S. Patent No. 2,750,395.

FORMULA II

A 3,4-epoxycyclohexylmethyl-3,4-epoxycyclohexane carboxylate having the formula:

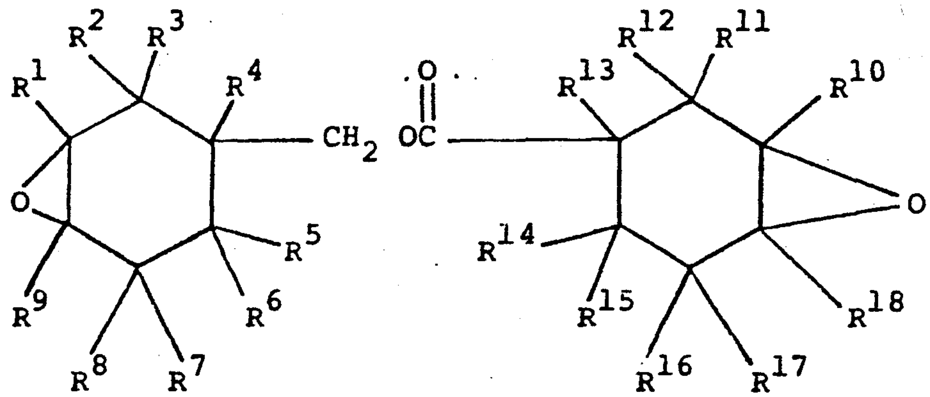

wherein $R^1$ through $R^{18}$ which can be the same or different are as defined for $R_1$ to $R_{18}$ in Formula I. Particularly desirable compounds are those wherein $R^1$ through $R^{18}$ are hydrogen.

Among specific compounds falling within the scope of Formula II are the following: 3,4-epoxycyclohexylmethyl-3,4-epoxycyclohexane carboxylate; 3,4-epoxy-1-methylcyclohexylmethyl-3,4-epoxy-1-methylcyclohexane carboxylate; 6-methyl-3,4-epoxycyclohexylmethyl-6-methyl-3,4-epoxycyclohexane carboxylate; 3,4-epoxy-3-methylcyclohexylmethyl-3,4-epoxy-3-methylcyclohexane carboxylate; 3,4-epoxy-5-methylcyclohexylmethyl-3,4-epoxy-5-methylcyclohexane carboxylate. Other suitable compounds are described in, for example, U.S. Patent No. 2,890,194.

FORMULA III

Diepoxides having the formula:

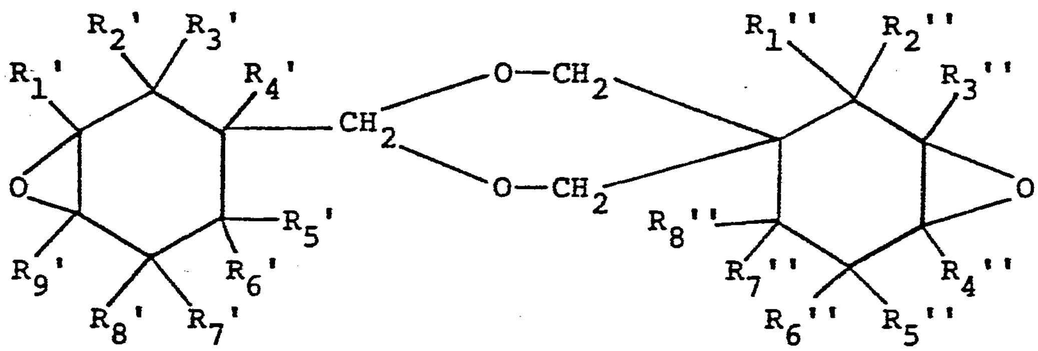

wherein the R single and double primes, which can be the same or different, are monovalent substituents such as hydrogen, halogen, i.e. chlorine, bromine, iodine or fluorine, or monovalent hydrocarbon radicals, or radicals as further defined in U.S. Patent No. 3,318,822. Particularly, desirable compounds are those wherein all the R's are hydrogen.

Other suitable cycloaliphatic epoxides are the following:

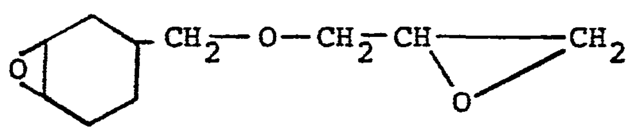

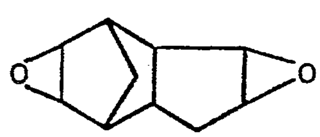

and the like.

The preferred cycloaliphatic epoxides are the following:

3,4-Epoxycyclohexylmethyl-3,4-Epoxy-cyclohexane carboxylate

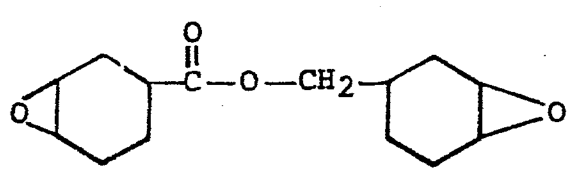

Bis(3,4-Epoxycyclohexylmethyl)adipate

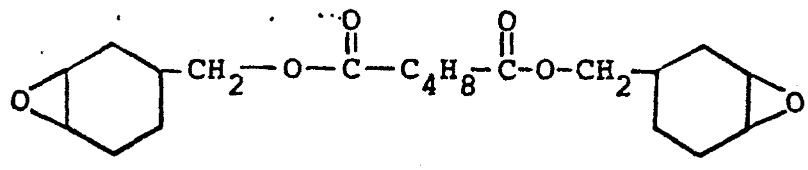

2-(3,4-Epoxycyclohexyl-5,5-spiro-3,4-epoxy)cyclohexane-meta-dioxane

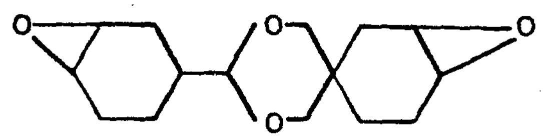

or mixtures thereof.

Epoxides with six membered ring structures may also be used, such as diglycidyl esters of phthalic acid, partially hydrogenated phthalic acid or fully hydrogenated phthalic acid. A representative diglycidyl ester of phthalic acid is the following:

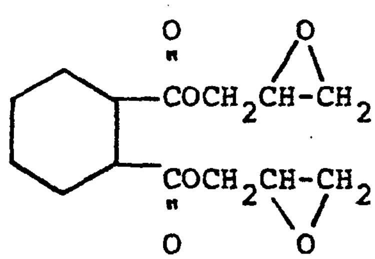

Diglycidyl esters of hexahydrophthalic acids being preferred.

The glycidyl-type epoxides are preferably diglycidyl ethers of bisphenol A which are derived from bisphenol A and epichlorohydrin and have the following formula:

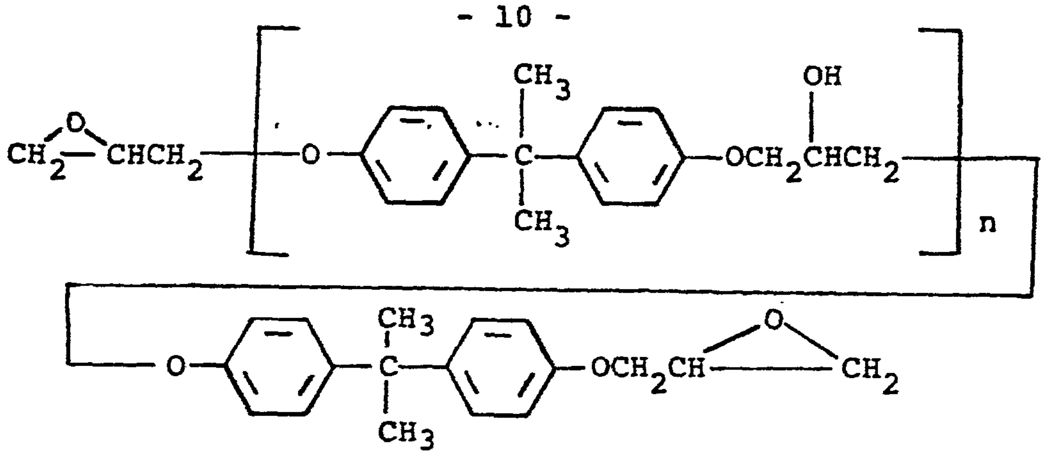

The cresol-novolac epoxy resins are multifunctional, solid polymers characterized by low ionic and hydrolyzable chlorine impurities, high chemical resistance, and thermal performance.

The epoxy phenol novolac resins are generally of the following formula:

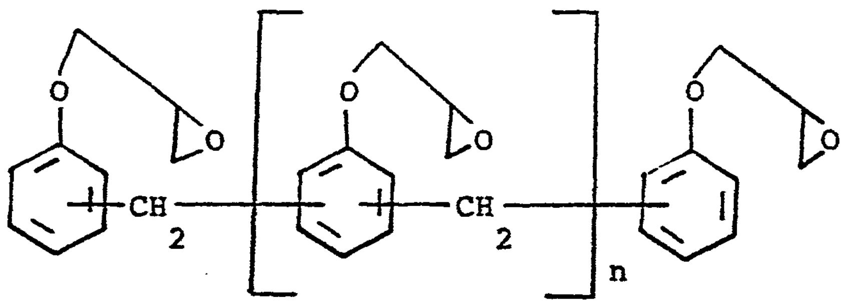

The polynuclear phenol-glycidyl ether-derived resins are generally of the formula:

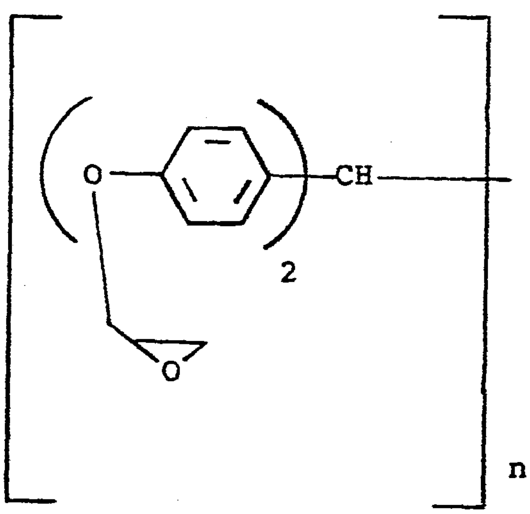

or

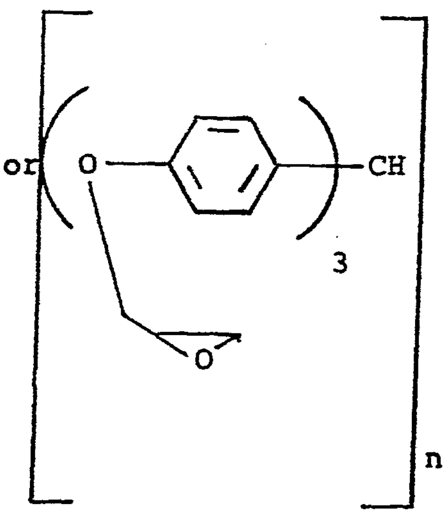

Among the aromatic and heterocyclic glycidyl amine resins which may be included herein are the following: tetraglycidylmethylenedianiline derived resins of the following formula:

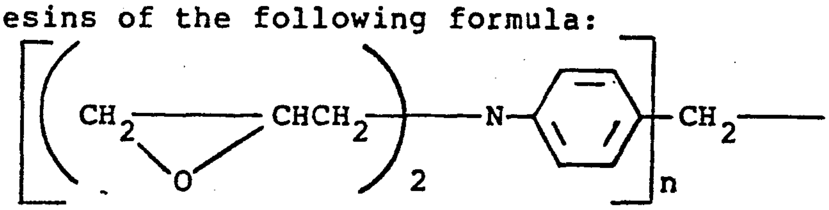

Triglycidyl-p-aminophenol derived resins, triazine based resins and hydantoin epoxy resins of the formula:

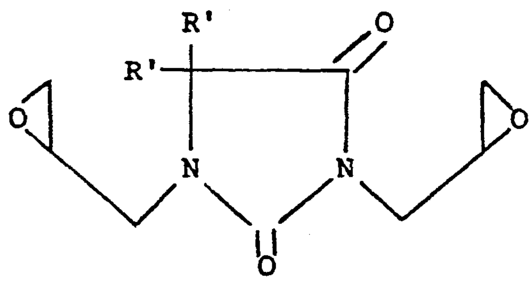

R' = $CH_3$

It is of course understood by those skilled in the art that when a photoinitiator is used only minor amounts of basic organic nitrogen containing epoxide compounds may be used so as not to interfere with the photocopolymerization reaction.

The photoinitiators which may be used herein include one or more of a metal fluoroborate and a complex of boron trifluoride, as described in U.S. Patent 3,379,653; a bis(perfluoroalkylsulfonyl)methane metal salt, as described in U.S. Patent 3,586,616; an aryldiazonium compound, as described in U.S. Patent 3,708,296; an aromatic onium salt of Group VIa elements, as described in

U.S. Patent 4,058,400; an aromatic onium salt of Group Va elements, as described in U.S. Patent 4,069,055; a dicarbonyl cheleate of a Group IIIa-Va element, as described in U.S. Patent 4,086,091; a thiopyrylium salt, as described in U.S. Patent 4,139,655; a Group VIa element having an $MF_6^-$ anion where M is selected from P, As and Sb, as described in U.S. Patent 4,161,478; a triarylsulfonium complex salt, as described in U.S. Patent 4,231,951; and an aromatic iodonium complex salt and an aromatic sulfonium complex salt, as described in U.S. Patent 4,256,828. Preferred photoinitiators include triarylsulfonium complex salts, aromatic sulfonium or iodonium salts of halogen-containing complex ions, and aromatic onium salts of Group IIIa, Va and VIa elements. Some of such salts are commercially available, such as FC-508 and FC-509 (available from Minnesota Mining and Manufacturing Company), and UVE-1014 (available from General Electric Company).

Preferred photoinitiators are described in U.S. Patent Application Serial No. (Docket No. D-13814) filed in the name of J.V. Koleske et al., titled Photoinitiator-Diluent Mixtures, and filed on the same date as this application. Said application describes compositions comprising (a) a photoinitiator selected from diazonium salts or onium salts, or mixtures thereof, and (b) a cycloaliphatic epoxide.

The photoinitiators are used in conventional amounts in the compositions of this invention such as in amounts from about 0.1 to 30 parts by weight per 100 parts by weight of the epoxides.

The compositions herein may include additives such as oils, particularly silicone oil, surfactants such as silicone-alkylene oxide copolymers and acrylic polymers, such as the Modaflows (obtained from Monsanto Chemical Co.), silicone oil containing aliphatic epoxide groups, fluorocarbon surfactants; low molecular weight alcohols; cellosolves, such as butyl cellosolve; carbitols, such as butyl carbitol and diethyleneglycol, and the like.

The compositions of this invention may be used together with a poly(active hydrogen) organic compound as described in U.S. Patent Application No. (Docket No. D-13813) filed in the name of J. V. Koleske et al., titled Photocopolymerizable Compositions Based On Epoxy and Hydroxyl-Containing Organic Materials And Substituted Cycloaliphatic Monoepoxide Reactive Diluents and filed on the same date as this application. Said application describes photocopolymerizable compositions comprising an epoxide containing two or more epoxy groups, a poly(active hydrogen) organic compound, a photoinitiator and a substituted cycloaliphatic monoepoxide.

The compositions of this invention may be used with the poly(active hydrogen) organic compound as described in U.S. Patent Application No. (Docket No. D-13,812) filed in he name of J. V. Koleske et al., titled Photocopolymerizable Compositions Based On Hydroxyl-Containing Organic Materials And Substituted Cycloaliphatic Monoepoxide Reactive Diluents and filed on the same date as this application. Said application describes photocopolymerizable compositions comprising a

poly(active hydrogen) organic compound, a photoinitiator and a substituted cycloaliphatic monoepoxide.

If desired, one may include in the compositions of this invention various conventional non-basic fillers (e.g., silica, talc, glass beads or bubbles, clays, powdered metal such as aluminum, silver, zinc oxide, etc.) and other additives such as rubbers, tackifying agents, pigments, and the like.

The photocopolymerizable compositions are particularly suitable in a variety of applications in the fields of protective coatings and graphic arts due to their flexibility, impact resistance, abrasion-resistance, hardness and adhesion to rigid, resilient and flexible substrates such as metal, plastic, rubber, glass, paper, wood, and ceramics.

The photopolymerization of the compositions of the invention occurs upon exposure of the compositions to any source of radiation emitting actinic radiation at a wavelength within the ultraviolet and visible spectral regions. Suitable sources of radiation include mercury, xenon, carbon arc lamps, sunlight, etc. Exposures may be from less than about 1 second to 10 minutes or more depending upon the amounts of particular polymerizable materials and photoinitiator being utilized and depending upon the radiation source and distance from the source and the thickness of the coating to be cured. The compositions may also be photopolymerized by exposure to electron beam irradiation. Generally speaking the dosage necessary is from less than 1 megarad to 100 megarads or more.

The compositions of this invention may be prepared simply by mixing the formulation ingredients together, preferably under "safe light" conditions when the photoinitiator is incorporated.

EXAMPLES

The following Examples serve to give specific illustration of the practice of this invention but they are not intended in any way to act to limit the scope of this invention.

The following designations used in the Examples have the following meaning:

Epoxy 1: 3,4-epoxycyclohexylmethyl-3,4-epoxycyclohexane carboxylate.

Epoxy 2: Bis(3,4-epoxycyclohexylmethyl) adipate.

Epoxy 3: 2-(3,4-epoxycyclohexyl-5,5-spiro-3,4-epoxy)cyclohexane-meta-dioxane.

Epoxy 4: an aromatic glycidyl epoxide (Epon 828 obtained from Shell) of the following formula:

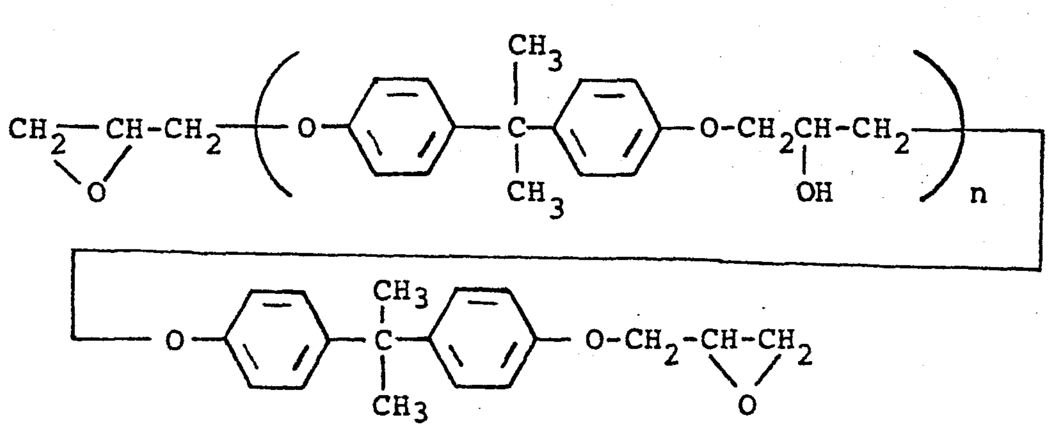

wherein n is 0.15.

<u>Monoepoxide</u>: vinyl cyclohexene monoepoxide.

<u>Surfactant</u>: A silicone surfactant with the structure

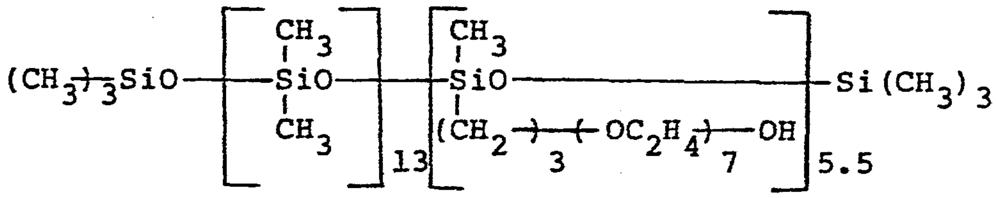

<u>Photoinitiator 1</u>: UVE-1014, a solution of a triarylsulfonium hexafluoroantimony salt with a specific gravity of 1.39 and a Brookfield viscosity of 74 centipoise (obtained from General Electric Co.).

<u>Photoinitiator 2</u>: FC-508, a solution of a triarylsulfonium hexafluorophosphate with a specific gravity of 1.33 and a Brookfield viscosity of 40,000 to 60,000 centipoise (obtained from Minnesota Mining and Manufacturing Company).

The procedures used to test coatings cured with the compositions of this invention were as follows:

Solvent Resistance (Double Acetone Rubs): a measure of the resistance of the cured film to attack by acetone in which a film coating surface was rubbed with an acetone soaked cheesecloth back and forth with hand pressure. A rub back and forth with hand pressure over the film coating surface with the acetone soaked cheesecloth was designated as one "double acetone rub". The effect that a certain number of double acetone rubs had on the film coating surface was reported by a number in parenthesis following the number of double acetone rubs. The rating system for evaluating acetone

resistance for a given number of double acetone rubs was as follows:

Number in Parenthesis After Number of Rubs

(1) No change in coating appearance.

(2) Scratched surface.

(3) Dulled, marred, some coating removed.

(4) Breaks in coating appearance.

(5) About one-half of the coating removed.

Pencil Hardness - ASTMD-3363-74

The rating system for pencil hardness was as follows:

6B-5B-4B-3B-2B-B-HB-F-H-2H-3H-4H-5H-6H

Softer Harder

Crosshatch adhesion - refers to a test using 10 parallel, single-edge, razor blades to scribe test films with 2 sets of perpendicular lines in a crosshatch pattern. Ratings are based on the amount of film removed after applying and subsequently pulling a contact adhesive tape (Scotch Brand 606) away from the surface of a scribed coating at a 90 degree angle in a fast, rapid movement. It is important to carefully apply and press the tape to the scribed coating to eliminate air bubbles and provide a good bond because adhesion is reported as the percent of film remaining on the substrate with a 100 percent rating indicating complete adhesion of the film in the substrate.

Reverse or face impact resistance - measures the ability of a given film to resist rupture from a falling weight. A Gardner Impact Tester using an eight-pound dart is used to test the films cast and cured on the steel panel. The dart is raised to a given height in inches and dropped onto the reverse

or face side of a coated metal panel. The inches times pounds, designated inch-pounds, absorbed by the film without rupturing is recorded as the reverse or face impact resistance of the film.

Example 1

This example describes the blending of Monoepoxide with Epoxy 1 in various ratios. It demonstrates the powerful viscosity reducing effect the vinyl cycloaliphatic monoepoxide has on this diepoxide. The two compounds were mixed at room temperature (about 25°C). The viscosity of the mixture was determined at 26°C with a Brookfield Viscometer.

The results are shown in Table I.

TABLE I

| Amount of Epoxy 1 (gm) | Amount of Monoepoxide (gm) | Viscosity (cps) |
|---|---|---|
| 100 | 0 | 524 |
| 95 | 5 | 300 |
| 90 | 10 | 172 |
| 85 | 15 | 94 |
| 80 | 20 | 68 |
| 70 | 30 | 44 |
| 60 | 40 | 32 |
| 0 | 100 | 10 |

It is readily apparent from the data that vinyl cyclohexene monoepoxide is a powerful diluent for cycloaliphatic epoxides.

Example 2

This example describes the combination of Epoxy 1 with Monoepoxide and 4% of two different photoinitiators.

Various amounts, as shown in Tables II and IV, of Epoxy 1, Monoepoxide, and either Photoinitiator 1 (Table II) or Photoinitiator 2 (Table IV) were placed in amber bottles while working under a yellow light source.

The systems were coated onto Bonderite 37 steel panels with a No. 20 wire-wound rod and cured with one pass (unless otherwise noted) under a 100 watt per inch medium pressure energy vapor UV light source at 30 feet per minute (fpm). The systems were aged at room temperature (about 25°) without a post cure and with a ten minute post cure at 170°C. The thickness of the cured coating varied from 0.65 mil to 1.0 mil.

This example demonstrates that combinations of the epoxides can be cured with ultraviolet light when photoinitiators of the onium salt type are used.

TABLE II

| Ingredients | System, Parts by Weight 1 | 2 | 3 | 4 | 5 | 6 | 7 | 8 | 9 |
|---|---|---|---|---|---|---|---|---|---|
| Monoepoxide | 0.0 | 4.8 | 9.6 | 19.2 | 38.4 | 48.0 | 72.0 | 86.4 | 96.0 |
| Epoxy 1 | 96.0 | 91.2 | 86.4 | 76.8 | 57.6 | 48.0 | 24.0 | 9.6 | 0.0 |
| Photoinitiator 2 | 4.0 | 4.0 | 4.0 | 4.0 | 4.0 | 4.0 | 4.0 | 4.0 | 4.0 |
| Monoepoxide (%) | 0 | 5 | 10 | 20 | 40 | 50 | 75 | 90 | 100 |

Comments on the formulations

| | | |
|---|---|---|
| System 1 | -- | Surface cure only with one pass. When given a second pass the coating was tack free when warm immediately after UV exposure. |
| Systems 2-5 | -- | Very slight tack immediately after UV exposure. Tack free in a few seconds after exposure and while still warm. |
| Systems 6-8 | -- | Light tack when warm immediately after UV exposure. Tack free when cooled to room temperature. System 8 had a decrease in gloss. |
| System 9 | -- | Tacky when warm immediately after UV exposure. Dry when cooled to room temperature. Two passes were needed to achieve this state. |

TABLE III

| Properties | System (No Post Cure, 1 Day at Room Temperature (about 25°C) after UV Exposure) | | | | | | | | |
|---|---|---|---|---|---|---|---|---|---|
| | 1 | 2 | 3 | 4 | 5 | 6 | 7 | 8 | 9 |
| Acetone Resistance | 20(4) | 45(4) | 45(4) | 35(5) | 35(5) | 15(5) | 10(5) | 5(5) | 2(5) |
| Pencil Hardness | 3H | 2H | F | H | F | F | HB | 2B | 4B |
| Cross-Hatch Adhesion (%) | 100 | 100 | 50 | 100 | 100 | 100 | 100 | 100 | 98 |
| Impact (in.lbs.) | | | | | | | | | |
| Face | 15 | 15 | 15 | 20 | 25 | 25 | 25 | 15 | 5 |
| Reverse | <5 | <5 | <5 | <5 | <5 | <5 | <5 | <5 | <5 |
| Thickness (mil) | 0.90 | 0.81 | 0.92 | 0.90 | 0.89 | 0.87 | 0.82 | 0.70 | 0.65 |

| Properties | System (Post Cured 10 min. at 170°C) | | | | | | | | |
|---|---|---|---|---|---|---|---|---|---|
| | 1 | 2 | 3 | 4 | 5 | 6 | 7 | 8 | 9 |
| Acetone Resistance | 30(4) | 50(4) | 45(4) | 35(4) | 35(4) | 15(4) | 10(4) | 20(4) | 2(5) |
| Pencil Hardness | 3H | 3H | 3H | 2H | 2H | 2H | H | H | 2B |
| Cross-Hatch Adhesion (%) | 100 | 100 | 100 | 100 | 100 | 100 | 100 | 100 | 100 |
| Impact (in.lbs.) | | | | | | | | | |
| Face | 15 | 15 | 15 | 15 | 15 | 15 | 15 | 15 | 10 |
| Reverse | <5 | <5 | <5 | <5 | <5 | <5 | <5 | <5 | <5 |
| Thickness (mil) | 0.71 | 0.80 | 0.80 | 0.80 | 0.82 | 0.92 | 0.82 | 0.85 | 0.75 |

## TABLE IV

| Ingredients | System, Parts by Weight | | | | | | | | |
|---|---|---|---|---|---|---|---|---|---|
| | 10 | 11 | 12 | 13 | 14 | 15 | 16 | 17 | 18 |
| Monoepoxide | 0.0 | 4.8 | 9.6 | 19.2 | 38.4 | 48.0 | 72.0 | 86.4 | 96.0 |
| Epoxy 1 | 96.0 | 91.2 | 86.4 | 76.8 | 57.6 | 48.0 | 24.0 | 9.6 | 0.0 |
| Photoinitiator 1 | 4.0 | 4.0 | 4.0 | 4.0 | 4.0 | 4.0 | 4.0 | 4.0 | 4.0 |
| Monoepoxide (%) | 0 | 5 | 10 | 20 | 40 | 50 | 75 | 90 | 100 |

Comments on the formulations

| | | |
|---|---|---|
| Systems 10-17 | -- | Tack free when warm immediately after UV exposure. |
| System 18 | -- | Two passes used. Light tack both times immediately after UV exposure, but tack free when cooled to room temperature. Slightly less glossy than other coatings. |

TABLE V

| Properties | System (No Post Cure, 1 Day at Room Temperature (about 25°C) after UV Exposure) | | | | | | | | |
|---|---|---|---|---|---|---|---|---|---|
| | 10 | 11 | 12 | 13 | 14 | 15 | 16 | 17 | 18 |
| Acetone Resistance | 100(1) | 100(1) | 100(1) | 100(1) | 100(2) | 100(3) | 15(4) | 5(5) | 2(5) |
| Pencil Hardness | 3H | 3H | 2H | 2H | H | H | H | HB | 4B |
| Cross-Hatch Adhesion (%) | 20 | 50 | 20 | 25 | 15 | 80 | 100 | 100 | 90 |
| Impact (in.lbs.) | | | | | | | | | |
| Face | 15 | 20 | 15 | 15 | 25 | 25 | 25 | 10 | 5 |
| Reverse | <5 | <5 | <5 | <5 | <5 | <5 | <5 | <5 | <5 |
| Thickness (mil) | 0.91 | 0.82 | 0.90 | 0.90 | 0.85 | 1.00 | 0.85 | 0.85 | 0.70 |

| Properties | System (Post Cured 10 min. at 170°C) | | | | | | | | |
|---|---|---|---|---|---|---|---|---|---|
| | 10 | 11 | 12 | 13 | 14 | 15 | 16 | 17 | 18 |
| Acetone Resistance | 100(1) | 100(1) | 100(1) | 100(1) | 100(1) | 100(1) | 50(4) | 20(4) | 2(5) |
| Pencil Hardness | 4H | 4H | 4H | 4H | 4H | 4H | 2H | H | 3B |
| Cross-Hatch Adhesion (%) | 100 | 100 | 100 | 100 | 100 | 100 | 100 | 100 | 98 |
| Impact (in.lbs.) | | | | | | | | | |
| Face | 25 | 15 | 25 | 25 | 25 | 25 | 15 | 10 | 10 |
| Reverse | <5 | <5 | <5 | <5 | <5 | <5 | <5 | <5 | <5 |
| Thickness (mil) | 0.85 | 0.90 | 0.90 | 0.81 | 0.87 | 0.85 | 0.90 | 0.82 | 0.85 |

Example 3

This Example shows the combination of Epoxy 2, with Monoepoxide, Photoinitiators 1 and 2, and the Surfactant.

The ingredients listed in Table VI were placed in amber bottles and mixed at room temperature (about 25°C) while working in an atmosphere substantially free of ultraviolet light. The viscosities were determined with a Brookfield viscometer at 23.9°C. Epoxy 2 has a viscosity of from 550 to 750 centipoise at 25°C.

## TABLE VI

| Ingredients, (grams) | System 1 | 2 | 3 | 4 | 5 | 6 | 7 | 8 |
|---|---|---|---|---|---|---|---|---|
| Monoepoxide | 1.2 | 4.8 | 12.0 | 21.6 | 2.4 | 4.8 | 9.6 | 18.0 |
| Epoxy 2 | 22.8 | 19.2 | 12.0 | 2.4 | 21.6 | 19.2 | 14.4 | 6.0 |
| Photoinitiator 1 | 1.0 | 1.0 | 1.0 | 1.0 | --- | --- | --- | --- |
| Photoinitiator 2 | --- | --- | --- | --- | 1.0 | 1.0 | 1.0 | 1.0 |
| Surfactant | 0.12 | 0.12 | 0.12 | 0.12 | 0.12 | 0.12 | 0.12 | 0.12 |
| Monoepoxide (%) | 5 | 20 | 50 | 90 | 10 | 20 | 40 | 75 |
| Viscosity (cps) | 400 | 90 | 20 | 10 | 270 | 100 | 15 | 10 |

The above systems were coated onto Bonderite 37 steel panels with a Number 20 wire-wound rod and cured with one pass under a 100 watt per inch, medium-pressure, UV light source at 30 feet per minute. The cured coatings were aged at room temperature (about 25°C) for at least one day or were post cured 10 minutes at 170°C before testing. Systems 1, 2, 5, and 6 were tack free when warm immediately after UV exposure. Systems 3, 4, 7, and 8 had a slight tack when warm immediately after UV exposure but were tack free when cooled to room temperature (about 25°) . Thus, all responded well to cure by UV radiation. All cured coatings were 0.85 mil thick.

The properties of the cured coatings are given in Table VII.

## TABLE VII

| | System | | | | | | | |
|---|---|---|---|---|---|---|---|---|
| **Properties (No Post Cure)** | 1 | 2 | 3 | 4 | 5 | 6 | 7 | 8 |
| Acetone Double Rubs | 75(4) | 65(4) | 25(4) | 5(5) | 100(4) | 45(4) | 34(4) | 8(5) |
| Pencil Hardness | H | H | F | HB | F | F | F | 2B |
| Crosshatch Adhesion (%) | 0 | 10 | 20 | 100 | 0 | 0 | 20 | 100 |
| **Gardner Impact (in.lbs.)** | | | | | | | | |
| Face | >320 | >320 | 75 | 25 | >320 | >320 | >320 | 25 |
| Reverse | >320 | >320 | 25 | <5 | >320 | >320 | >320 | 5 |
| **Properties (After Post Thermal Cure)** | | | | | | | | |
| Acetone Double Rubs | 100(1) | 100(1) | 100(3) | 16(4) | 100(1) | 100(1) | 100(4) | 40(4) |
| Pencil Hardness | H | H | F | HB | F | F | F | F |
| Crosshatch Adhesion (%) | 100 | 100 | 100 | 100 | 100 | 100 | 100 | 100 |
| **Gardner Impact (in.lbs.)** | | | | | | | | |
| Face | >320 | >320 | 10 | 10 | >320 | >320 | >320 | 10 |
| Reverse | >320 | >320 | <5 | <5 | >320 | >320 | >320 | <5 |

## Example 4

This is another example of the UV curing of an all-epoxide system. The ingredients listed in Table VIII were mixed as described in Example 3. The Brookfield viscosities of the systems were determined at a temperature of 23.9°C. Epoxy 3 has a viscosity of from 7,000 to 17,000 centipoise at 38°C.

TABLE VIII

| Ingredients (grams) | System 1 | 2 | 3 | 4 | 5 |
|---|---|---|---|---|---|
| Monoepoxide | 4.8 | 9.6 | 18.0 | 4.8 | 9.6 |
| Epoxy 3 | 19.2 | 14.4 | 6.0 | 19.2 | 14.4 |
| Photoinitiator 2 | -- | -- | -- | 1.0 | 1.0 |
| Photoinitiator 1 | 1.0 | 1.0 | 1.0 | -- | -- |
| Surfactant | 0.12 | 0.12 | 0.12 | 0.12 | 0.12 |
| Monoepoxide (%) | 19.1 | 38.2 | 71.7 | 19.1 | 38.2 |
| Viscosity (cps) | 465 | 20 | 10 | 465 | 20 |

The above systems were coated onto Bonderite 37 steel panels and cured in the manner described in Example 3. Systems 1, 2, and 4 were tack free when warm immediately after UV exposure. Systems 3 and 5 had a slight tack when warm immediately after UV exposure but were tack free when cooled to room temperature (about 25°C). Cured coating thickness varied from 0.8 to 0.9 mil.

The properties of the cured coatings is given in Table IX.

TABLE IX

| Properties (No Post Cure) | System 1 | 2 | 3 | 4 | 5 |
|---|---|---|---|---|---|
| Acetone Double Rubs | 100(2) | 100(2) | 15(5) | 8(5) | 5(5) |
| Pencil Hardness | H | H | F | F | F |
| Crosshatch Adhesion (%) | 95 | 95 | 95 | 98 | 99 |
| Gardner Impact, (in.lbs.) | | | | | |
| Face | 10 | 10 | 5 | 5 | 5 |
| Reverse | <5 | <5 | <5 | <5 | <5 |
| Properties, (After Post Thermal Cure) | | | | | |
| Acetone Double Rubs | 100(1) | 100(1) | 100(3) | 10(5) | 10(5) |
| Pencil Hardness | H | H | H | H | H |
| Crosshatch Adhesion (%) | 98 | 98 | 100 | 98 | 98 |
| Gardner Impact (in.lbs.) | | | | | |
| Face | 5 | 10 | 5 | 5 | 5 |
| Reverse | <5 | <5 | <5 | <5 | <5 |

Example 5

This is another example of all-epoxide systems that contains the Monoepoxide and combinations of Epoxy 1, Epoxy 2 and Epoxy 3 with Photoinitiators 1 or 2 and the Surfactant. The ingredients listed in Table X were mixed as described in Example 3.

TABLE X

| Ingredients (grams) | System 1 | 2 | 3 | 4 | 5 | 6 | 7 | 8 | 9 | 10 | 11 |
|---|---|---|---|---|---|---|---|---|---|---|---|
| Monoepoxide | 2.5 | 5.0 | 10.0 | 5.0 | 5.0 | 5.0 | 5.0 | 5.0 | 5.0 | 5.0 | 5.0 |
| Epoxy 1 | 16.13 | 14.24 | 10.5 | 14.24 | 9.5 | 9.5 | 4.75 | 4.75 | 14.24 | --- | 6.33 |
| Epoxy 2 | 5.37 | 4.75 | 3.5 | 4.75 | 9.5 | 9.5 | 14.25 | 14.25 | --- | 9.5 | 6.33 |
| Epoxy 3 | --- | --- | --- | --- | --- | --- | --- | --- | 4.75 | 9.5 | 6.33 |
| Photoinitiator 2 | 1.0 | 1.0 | 1.0 | --- | 1.0 | --- | 1.0 | --- | --- | --- | --- |
| Photoinitiator 1 | --- | --- | --- | 1.0 | --- | 1.0 | --- | 1.0 | 1.0 | 1.0 | 1.0 |
| Surfactant | 0.125 | 0.125 | 0.125 | 0.125 | 0.125 | 0.125 | 0.125 | 0.125 | 0.125 | 0.125 | 0.125 |
| Monoepoxide (%) | 10 | 20 | 40 | 20 | 20 | 20 | 20 | 20 | 20 | 20 | 20 |

The above systems were coated onto Bonderite 37 steel panels and cured in the same manner as described in Example 3 except coatings were aged for 3 days at room temperature (about 25°) after UV cure. Cured coating thickness varied from 0.8 to 0.9 mil. (All coatings were tack free when warm immediately after UV exposure)

The properties of the cured coatings are given in Table XI.

TABLE XI

| Properties (No Post Cure) | System | | | | | | | | | | |
|---|---|---|---|---|---|---|---|---|---|---|---|
| | 1 | 2 | 3 | 4 | 5 | 6 | 7 | 8 | 9 | 10 | 11 |
| Acetone Double Rubs | 100(3) | 15(5) | 15(5) | 100(1) | 100(3) | 100(1) | 80(4) | 100(1) | 100(1) | 100(1) | 100(1 |
| Pencil Hardness | H | F | H | H | H | H | H | H | H | H | H |
| Crosshatch Adhesion (%) | 100 | 100 | 100 | 100 | 100 | 100 | 100 | 100 | 100 | 100 | 100 |
| Gardner Impact (in.lbs.) | | | | | | | | | | | |
| Face | 25 | 25 | 25 | 25 | 25 | 25 | 25 | 25 | 25 | 15 | 15 |
| Reverse | <5 | <5 | <5 | <5 | <5 | <5 | <5 | <5 | <5 | <5 | <5 |

Example 6

This example describes the blending of the Monoepoxide with Epoxy 4. It demonstrates the powerful viscosity reducing effect the monoepoxide has on aromatic type epoxides. The viscosities were determined with a Brookfield viscometer at the temperature shown in Table XII.

TABLE XII

| Amount of Epoxy 4 (gm.) | Amount of Monoepoxide (gm.) | Weight Percent Monoepoxide | Viscosity, cps (°C) |
|---|---|---|---|
| 174.6 | -- | 0 | 13,560(26.6) |
| 174.6 | 20.0 | 10.28 | 2,868(27.0) |
| 174.6 | 40.0 | 18.64 | 303(27.5) |
| 174.6 | 60.0 | 25.58 | 135(27.5) |

0118748

CLAIMS

1. A composition suitable for photocopolymerization comprising:

(a) an epoxide containing two or more epoxy groups, and

(b) a substituted cycloaliphatic monoepoxide.

2. A composition as defined in claim 1 wherein the substituents on the substituted cycloaliphatic monoepoxide are alkyl of 2 to 9 carbon atoms, halogen, oxygen, ether, ester or a vinyl radical.

3. A composition as defined in claims 1 or 2 wherein the substituted cycloaliphatic monoepoxide is vinyl substituted cycloaliphatic monoepoxide, preferably a compound of the formula:

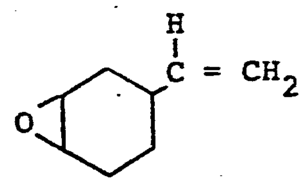

,

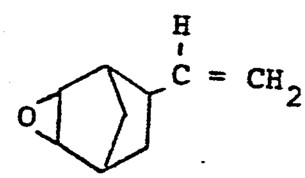

or

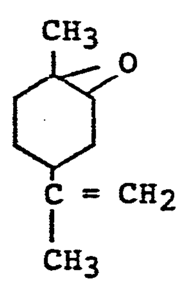

4. A composition as defined in claim 1 or 2 wherein the epoxide is a cycloaliphatic epoxide.

5. A composition as in claim 4 wherein the cycloaliphatic epoxide has the formula:

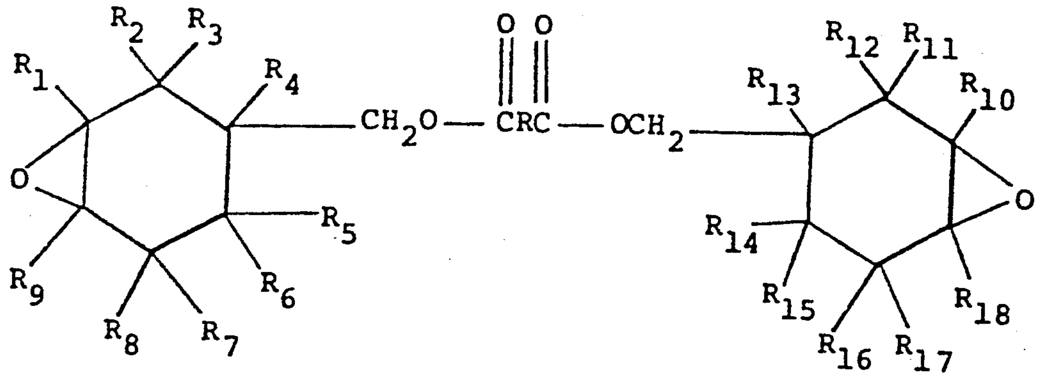

wherein $R_1$ through $R_{18}$, which can be the same or different, are hydrogen or alkyl radicals generally containing one to nine carbon atoms inclusive; R is a valence bond or a divalent hydrocarbon radical generally containing one to twenty carbon atoms inclusive,

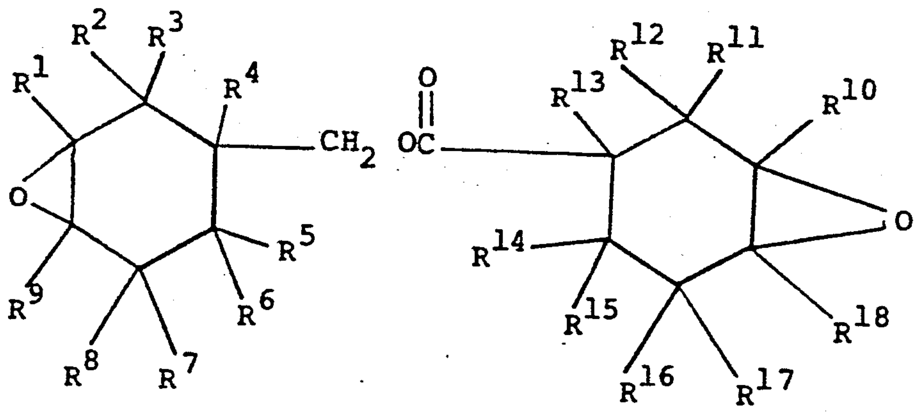

wherein $R^1$ through $R^{18}$, which can be the same or different are hydrogen or alkyl radicals generally containing one to nine carbon atoms inclusive, or

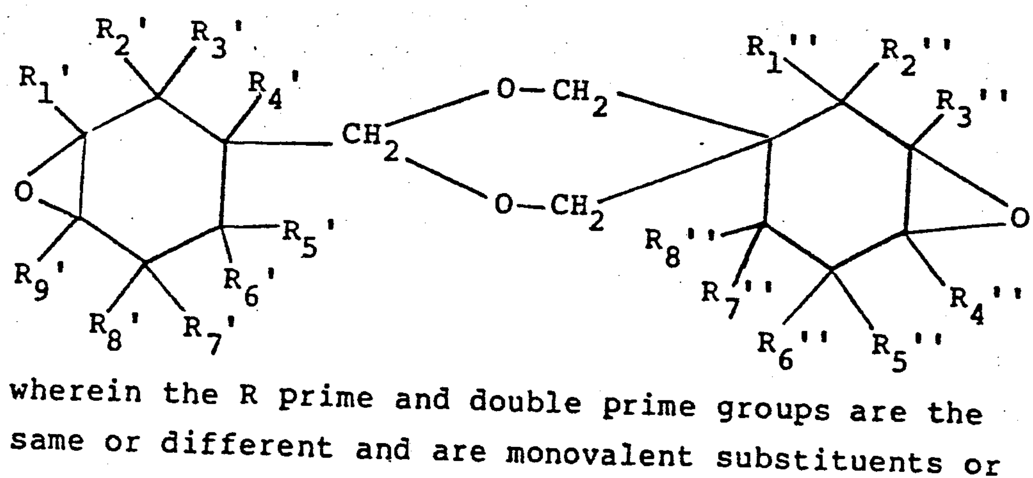

wherein the R prime and double prime groups are the same or different and are monovalent substituents or monovalent hydrocarbon radicals.

6. A composition as in claim 4 wherein the cycloaliphatic epoxide is 3,4-epoxycyclohexylmethyl-3,4-epoxycyclohexane carboxylate, bis (3,4-epoxycyclohexylmethyl)-adipate or 2-(3,4-epoxycyclohexyl-5,5-spiro-3,4-epoxy)-cyclohexane-meta-dioxane.

7. A composition as in claim 4 wherein the cycloaliphatic epoxide is a mixture of bis (3,4-epoxycyclohexylmethyl)adipate and 2-(3,4-epoxycyclohexyl-5,5-spiro-3,4-epoxy)-cyclohexane-meta-dioxane or a mixture of 3,4-epoxycyclohexylmethyl-3,4-epoxycyclohexane carboxylate and bis(3,4-epoxycyclohexylmethyl) adipate, which optionally includes 2-(3,4-epoxycyclohexyl)-5,5-spiro-3,4-epoxy)cyclohexane-meta-dioxane.

8. A composition as defined in claim 4 which contains minor amounts of one or more glycidyl type epoxides, aliphatic epoxides, epoxy cresol novolac resins, epoxy phenol novolac resins, polynuclear phenol-glycidyl ether-derived resins aromatic and heterocyclic glycidyl amine resins or hydantoin epoxy resins.

9. A composition suitable for photocopolymerization comprising:

(a) 3,4-epoxycyclohexylmethyl-3,4-epoxy cyclohexane carboxylate, and

(b) a vinyl cycloaliphatic monoepoxide of the formula:

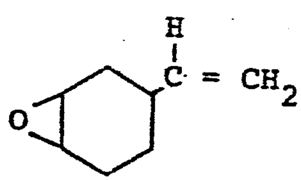

10. A composition as defined in claim 9 wherein the vinyl cycloaliphatic monoepoxide is present in amounts of from about 3 to about 30 weight percent.

11. A composition as defined in any of claims 1 to 10 which contains a photoinitiator, preferably diazonium salts or onium salts, or mixtures thereof.

12. A composition as defined in any of claims 1 to 11 which contains a surfactant.

13. A cured coating prepared from the composition of claims 11 or 12.

European Patent Office

# EUROPEAN SEARCH REPORT

0118748
Application number

EP 84101195.0

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| X | DE - B - 1 137 212 (CHEMISCHE WERKE WITTEN)<br>* Column 1, lines 30-48 *<br>-- | 1-3 | C 08 G 59/20<br>C 08 L 63/00<br>C 08 G 59/68<br>C 08 K 5/15 |
| X | SOVIET INVENTIONS ILLUSTRATED, section Ch, week C 32, September 17, 1980<br>DERWENT PUBLICATIONS LTD., London, A 21<br>* SU-703-551 (PETKO) *<br>-- | 1,4-6 | |
| A | H. JAHN, "Epoxiharze", 1969<br>VEB Deutscher Verlag für Grundstoffindustrie, Leipzig pages 26-30<br>* Page 26, last two sentences; page 27, lines 1,2; page 27, second row of formulae; page 29, last two rows of formulae; page 30, formulae *<br>-- | 1-8 | |
| A | US - A - 4 319 974 (J. CRIVELLO)<br>* Claims 1,3 *<br>---- | 1,11, 13 | |

TECHNICAL FIELDS SEARCHED (Int. Cl. 3)

C 08 G 59/00
C 08 L 63/00
C 08 K

The present search report has been drawn up for all claims

| Place of search | Date of completion of the search | Examiner |
|---|---|---|
| VIENNA | 07-05-1984 | KALTENEGGER |

**CATEGORY OF CITED DOCUMENTS**

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons
& : member of the same patent family, corresponding document

EPO Form 1503. 03.82